## Europäisches Patentamt

## European Patent Office

## Office européen des brevets

(19)

(11) Veröffentlichungsnummer: **0 224 483**
**B1**

(12) # EUROPÄISCHE PATENTSCHRIFT

(45) Veröffentlichungstag der Patentschrift:
**24.05.89**

(51) Int. Cl.⁴: **H 05 K 1/14**

(21) Anmeldenummer: **85903650.1**

(22) Anmeldetag: **11.07.85**

(86) Internationale Anmeldenummer:
**PCT/DE 85/00238**

(87) Internationale Veröffentlichungsnummer:
**WO 86/02230 (10.04.86** Gazette 86/8)

(54) SCHALTUNGSHYBRID FÜR ELEKTRONISCHE SCHALTUNGEN.

(30) Priorität: **27.09.84 DE 8428437 U**

(43) Veröffentlichungstag der Anmeldung:
**10.06.87 Patentblatt 87/24**

(45) Bekanntmachung des Hinweises auf die Patenterteilung:
**24.05.89 Patentblatt 89/21**

(84) Benannte Vertragsstaaten:
**DE FR IT SE**

(56) Entgegenhaltungen:
**DE-A- 2 441 209**
**DE-A- 3 010 876**
**DE-B- 1 790 126**
**FR-A- 2 273 377**

**IBM Technical Disclosure Bulletin, vol. 9, issue 10,
March 1967, New York (US), D.O. Johnson Jr.: "Terminal
clip for printed circuit card", p. 1306**

(73) Patentinhaber: **ROBERT BOSCH GMBH, Postfach 50,
D-7000 Stuttgart 1 (DE)**

(72) Erfinder: **ZÖBL, Hartmut, Moststrasse 25, D-8510 Fürth
(DE)**

ACTORUM AG

## Beschreibung

Die Erfindung geht aus von einem elektronische Bauteile aufweisenden Schaltungshybriden für eine elektronische Schaltung nach der Gattung des Hauptanspruchs.

Bei einer bekannten Lösung (DE-OS 31 46 608) wird für eine Hybridschaltung ein plattenförmiges Substrat verwendet, das auf der einen Seite mit verschiedenen elektronischen Schaltungselementen versehen ist. Über Leiterbahnen werden die Schaltungselemente auf einer Seitenkante des Substrates mit Anschlusspins kontaktiert, die am Substrat mechanisch befestigt sind. Die Anschlusspins werden in entsprechenden Bohrungen einer Leiterplatte der elektronischen Schaltung eingeführt und an deren Rückseite durch Lötung mit der Schaltung auf der Leiterplatte verbunden. Bei dieser Lösung ist nachteilig, dass die elektronischen Schaltungselemente auf nur einer Seite einer entsprechend grossen Substratplatte des Hybriden angeordnet sind. Fehlerhafte Teile des Schaltungshybriden können erst nach dem Boden durch eine vollständige Prüfung ermittelt werden, so dass in solchen Fällen der ganze Schaltungshybrid ausgeschieden und eventuell nachgearbeitet werden muss. Nachteilig ist ferner, dass ein solcher Schaltungshybrid einen relativ grossen Platz einnimmt. Ausserdem werden bei der bekannten Lösung die Abmessungen des Hybriden durch den für die Lötung erforderlichen Mindestabstand der Anschlusspins bestimmt, was bei einer hohen Zahl von Anchlusspins ebenfalls nachteilig ist.

Es ist ferner bekannt (IBM-Technical Disclosure Bulletin, Band 9, Heft 10, März 1967, Seite 1306), zwei gedruckte Schaltungen flach aufeinanderzulegen und auf einer Seite, an einer auf gleicher Höhe liegenden Kante U- bzw. S-förmige metallische Kontaktbrücken an den dort angeordneten Kontaktierungsstellen der Platten aufzusetzen, um durch diese Kontaktbrücken die Kontaktierungsstellen miteinander elektrisch zu verbinden und ausserdem einen Anschluss für eine Tragplatte zu gewinnen. Durch das Aufeinanderlegen der beiden gedruckten Schaltungen wird zwar der für den Einbau der gedruckten Schaltungen benötigte Raum besser genutzt, wobei jedoch für die durch zwei gedruckte Schaltungen wesentlich höhere Zahl der Anschlüsse an den nebeneinanderliegenden Schweiss- oder Lötanschlüssen der erforderliche Mindestabstand einzuhalten ist.

Mit der vorliegenden Lösung wird angestrebt, die Ausfallraten bei der Prüfung der Schaltungshybriden zu verringern, den Platzbedarf für die Schaltungshybride klein zu halten und die Anschlüsse so anzuordnen, dass unter Beibehaltung des erforderlichen Mindestabstandes der Anschlusspins der Abstand der nebeneinanderliegenden Kontaktbrücken praktisch halbiert werden kann.

### Vorteile der Erfindung

Die erfindungsgemässe Lösung mit den kennzeichnenden Merkmalen des Hauptanspruchs hat den Vorteil, dass die Abmessung des Schaltungshybriden bezüglich seiner Länge oder Breite durch die dicht nebeneinanderliegenden Kontaktbrükken sich praktisch halbieren lässt. Die plattenförmigen Hybridhälften können getrennt voneinander hergestellt und geprüft werden, so dass gegebenenfalls nur fehlerhafte Hybridhälften ausgeschieden werden. Auf diese Weise lassen sich die durch Ausfälle entstehenden Kosten insbesondere dann stark verringern, wenn ein relativ teures Schaltungselement, wie beispielsweise ein Mikroprozessor auf der einen Substratplatte und die übrigen Hardwareteile auf der anderen Susbtratplatte aufgebracht sind. Als weiterer Vorteil ist anzusehen, dass die auf mindestens einer Seitenkante des Schaltungshybriden aufgesetzten Kontaktbrücken nicht nur den mechanischen Zusammenhalt der beiden Substratplatten sichern, sondern ohne Anschlusspin auch noch Kontaktstellen beider Substratplatten miteinander verbinden können. Durch die versetzte Abkröpfung der Anschlusspins der nebeneinaderliegenden Kontaktbrücken wird ferner eine stabile Befestigung der Schaltungshybriden auf der Leiterplatte geschaffen, so dass auf eine zusätzliche Halterung der Schaltungshybriden verzichtet werden kann. Die Anschlusspins sind dabei zum Einsetzen in entsprechende Bohrungen der Leiterplatte mehrere Millimeter lang, so dass sie auf der dem Schaltungshybriden abgewandten Seite der Leiterplatte zur Kontaktierung durch Löten etwas vorstehen.

Durch die in den Unteransprüchen aufgeführten Massnahmen sind vorteilhafte Weiterbildungen und Verbesserungen der im Hauptanspruch angegebenen Merkmale möglich. So können zusätzliche mechanische Beanspruchen an den metallischen Kontaktbrücken dadurch verringert werden, dass die beiden Substrate des Schaltungshybriden gleiche Abmessungen haben und sandwichartig miteinander verklebt sind. Damit wird ferner die Handhabung des Schaltungshybriden bei der Anbringung von anzubringenden Kontaktbrücken erleichtert. Bei einer Vielzahl von anzubringenden Kontaktbrücken wird zur Verringerung der Abmessungen des Schaltungshybriden vorgeschlagen, die beiden aufeinanderliegenden Substrate auf zwei vorzugsweise einander gegenüberliegenden Seiten über die U-förmigen Kontaktbrücken miteinander elektrisch zu verbinden.

### Zeichnung

Ein Ausführungsbeispiel der Erfindung ist in der Zeichnung dargestellt und in der nachfolgenden Beschreibung näher erläutert. Es zeigen:

Figur 1 den erfindungsgemässen Schaltungshybriden in vergrösserter Darstellung im Querschnitt auf einer als Ausbruch erkennbaren Leiterplatte,

Figur 2 zeigt den Schaltungshybriden in der Vorderansicht, und

Fig. 3 in der Draufsicht.

### Beschreibung des Ausführungsbeispieles

In der Zeichnung ist ein Schaltungshybrid für einen Fahrdatenrechner im Kraftfahrzeug mit 10 bezeichnet. Er besteht aus zwei getrennt hergestellten plattenförmigen, rechteckigen Substraten
11 und 12 in Form von Keramikplättchen gleicher
Grösse. Das Substrat 11 trägt einen Mikroprozessor-Chip 13 und das Substrat 12 trägt weitere zum
Fahrdatenrechner gehörende Hardware-Bauteile
14 wie Widerstände, Kondensatoren, Dioden,
Transistoren und dergleichen. Auf den Substraten
11 und 12 werden ferner durch Dickschicht- oder
Dünnschichttechnik Leiterbahnen und gegebenenfalls Widerstände und Kondensatoren hergestellt, wobei die elektronischen Bauteile 13 und 14
mit den Leiterbahnen der Substrate 11 und 12
durch Bonden kontaktiert werden.

Um die Ausfallraten bei der Herstellung des
Schaltungshybriden 10 gering zu halten, wird das
Substrat 11 nach dem Aufbringen des Mikroprozessor-Chips 13 und dem Bonden und nach der
Abdeckung dieses Bereichs mit einer Silikonmasse 15 vollständig geprüft. Fehlerhafte Teile werden
erkannt, ausgeschieden und eventuell nachgearbeitet. Das andere Substrat 12 mit den Hardware-
Bauteilen 14 wird ebenfalls nach der Fertigstellung geprüft und gegebenenfalls abgeglichen.
Auch hier werden die fehlerhaften Teile ausgeschieden und gegebenenfalls nachgearbeitet.
Nach den Prüfungen werden die beiden Substrate
11 und 12 mit ihrer Rückseite mit einer Klebemasse
16 versehen und sandwichartig miteinander verklebt. Da die beiden Substrate 11 und 12 gleiche
Abmessungen haben, liegen ihre Kanten an allen
vier Seiten jeweils auf gleicher Höhe. Mit U-förmigen metallischen Kontaktbrücken 17 und 18, die
auf den Längsseiten 10a und 10b des so gebildeten Schaltungshybriden 11 aufgesetzt werden,
lassen sich die Leiterbahnen auf den beiden Substraten 11 und 12 durch Lötungen 19 elektrisch
miteinander verbinden.

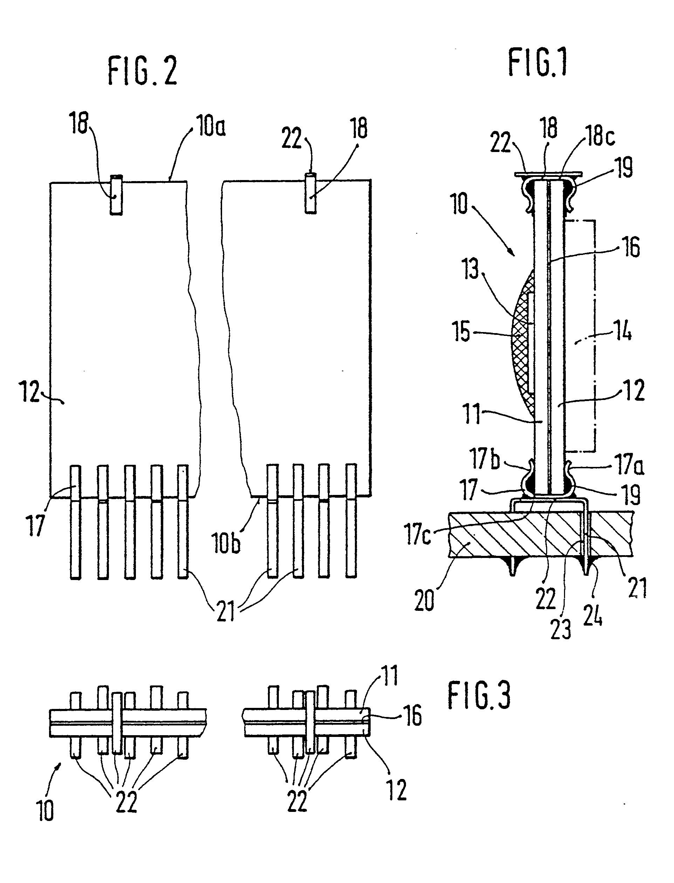

Zur Kontaktierung des Schaltungshybriden 10
mit einer Leiterplatte 20 sind die Kontaktbrücken
17 an der dafür vorgesehenen Längsseite des
Schaltungshybriden 10 mit Anschlusspins 21 versehen, die jeweils im Bereich des einen Schenkels
17a bzw. 17b der jeweiligen Kontaktbrücke 17 in
entgegengesetzter Richtung zum Schenkel 17a
bzw. 17b abgekröpft sind. In Figur 1 ist erkennbar,
dass am mittleren Jochbereich 17c, 18c der U-
förmigen Kontaktbrücken 17 und 18 ein metallischer Steg 22 angebracht ist. Zur Kontaktierung
des Schaltungshybriden 10 mit der Leiterplatte 20
sind an den dafür vorgesehenen Kontaktbrücken
17 die Stege 22 an ihrem einen, über dem Jochbereich 17c seitlich vorstehenden Ende als Anschlusspin 21 ausgebildet und dazu rechtwinklig
abgebogen. Die nicht zur Kontaktierung der Leiterplatte 20 vorgesehenen Anschlussbrücken 18
des Schaltungshybriden 10 sind zweckmässigerweise auf der gegenüberliegenden Längsseite des
Schaltungshybriden 10 angeordnet und nicht mit
Anschlusspins versehen. Zur Begrenzung der Abmessungen des Schaltungshybriden 10 bei einer
Vielzahl von Kontaktierungen mit der Leiterplatte
20 werden die dafür vorgesehenen Kontaktbrükken 17 an einer Seite des Schaltungshybriden 10
dicht nebeneinander angeordnet. Ihre Anschlusspins 21 sind dabei abwechselnd im Bereich des
einen Schenkels 17a bzw. des anderen Schenkels
17b abgekröpft. Dies wird in einfacher Weise dadurch bewerkstelligt, dass die benachbarten Kontaktbrücken 17 um jeweils 180° gedreht auf den
Hybriden 10 aufgesetzt und verlötet werden. Für
die Befestigung des Schaltungshybriden 10 auf
der Leiterplatte 20 werden die mehrere Millimeter
langen Anschlusspins 21 in entsprechende Bohrungen 23 der Leiterplatte eingeschoben und
durch Lötpunkte 24 an der dem Schaltungshybriden 10 abgewandten Seite der Leiterplatte 20 mit
den entsprechenden Leiterbahnen der Leiterplatte
20 kontaktiert.

Auf diese Weise ist es möglich, bei einem erforderlichen Rastermass von 2,54 mm für die Lötpunkte 24 durch die versetzte Abkröpfung der Anschlusspins 21 der benachbarten Kontaktbrücken
17 diese mit einem Rastermass von 1,27 mm
nebeneinander an der Längsseite des Schaltungshybriden 10 anzuordnen und damit die Abmessungen des Schaltungshybriden 10 gering zu halten. Ausserdem wird durch die versetzte Abkröpfung der Anschlusspins 21 eine Befestigung und
Halterung des Schaltungshybriden 10 auf der Leiterplatte 20 erzielt, die eine hohe mechanische
Festigkeit hat und damit zusätzliche Massnahmen
oder Teile zur Abstützung des Hybriden entbehrlich macht.

Patentansprüche

1. Elektrische Bauteile aufweisender Schaltungshybrid für eine elektronische Schaltung, mit
einer Vielzahl von elektrischen Kontaktierungsstellen, wobei der Schaltungshybrid (10) auf zwei
getrennt herstellbaren plattenförmigen Substraten
(11, 12) besteht, die mit ihrer Rückseite flach aufeinanderliegen und auf einer Seite an einer auf
gleicher Höhe liegenden Kante (10a, 10b) an den
dort angeordneten Kontaktierungsstellen durch
U-förmige auf den Kantenbereich aufgeschobene
metallische Kontaktbrücken (17, 19) miteinander
elektrisch verbunden sind, dadurch gekennzeichnet, dass die beiden Substrate (11, 12) des Schaltungshybriden (10) an ihren einander abgewandten Seiten mit elektronischen Bauteilen (13, 14)
versehen sind und dass die an der mindestens einen Seite (10a) des Schaltungshybriden (10)
dicht nebeneinander angeordneten Kontaktbrükken (17) mit Anschlusspins (21) versehen sind,
die abwechselnd im Bereich des einen Schenkels
(17a) und des anderen Schenkels (17b) der jeweiligen Kontaktbrücke (17) in entgegengesetzter Richtung zum Schenkel (17a, b) abgekröpft
sind.

2. Schaltungshybrid nach Anspruch 1, dadurch
gekennzeichnet, dass die U-förmigen Kontaktbrücken (17, 18) auf zwei vorzugsweise einander
gegenüberliegenden Seiten (10a, 10b) der beiden
aufeinanderliegenden Substrate (11, 12) angeordnet sind.

3. Schaltungshybrid nach Anspruch 2, dadurch
gekennzeichnet, dass am Jochbereich (17c) der U-förmigen Kontaktbrücken (17) ein metallischer Steg (22) angebracht ist, dessen eines über den Jochbereich (17b) der Kontaktbrücke (17) vorstehendes Ende als Anschlusspin (21) in entgegengesetzte Richtung zum Schenkel (17a, 17b) abgewinkelt ist.

## Claims

1. Hybrid circuit for an electronic circuit exhibiting elektric components, comprising a large number of electric contacting points, in which arrangement the hybrid circuit (10) consists of two separately producable plate-shaped substrates (11, 12) which rest flat on one another with their rear side and are electrically connected to one another by means of U-shaped metallic contact links (17, 18), which are pushed onto the edge area on one side, at an edge (10a, 10b) which is at the same level at the contacting points arranged there, charactetized in that the two substrates (11, 12) of the hybrid circuit (10) are provided with electronic components (13, 14) on their sides facing away from one another and that the contact links (17) arranged closely next to one another on at least one side (10a) of the hybrid circuit (10) are provided with connecting pins (21), which are alternatively bent away in the area of one leg (17a) and the other leg (17b) of the respective contact link (17) in opposite direction from the leg (17a, b).

2. Hybrid circuit according to Claim 1, charactterized in that the U-shaped contact links (17, 18) are arranged on two preferably mutually opposite sides (10a, 10b) of the two substrates (11, 12) which are resting on one another.

3. Hybrid circuit according to Claim 2, charactterized in that at the yoke area (17c) of the U-shaped contact links (17) a metallic bar (22) is attached, the one end of which, which protrudes over the yoke area (17b) of the contact link (17), is angled away as connecting pin (21) in the opposite direction from the leg (17a, 17b).

## Revendications

1. Montage hybride présentant des composants électroniques pour un circuit électronique, avec un grand nombre de points de connexion électrique, dans lequel le montage hybride (10) est constitué de deux substrats (11, 12), en forme de plaque, fabricables séparément, qui sont plaqués l'un sur l'autre sur leur face arrière et qui sont reliés électriquement sur un côté sur une arête (10a, 10b) située à la même hauteur, aux points de connexion qui y sont situés, par des cavaliers de contact (17, 18) métalliques en forme de U enfoncés sur le bord, caractérisé en ce que les deux substrats (11, 12) du montage hybride (10) sont pourvus, sur leurs faces opposées, de composants électroniques (13, 14) et que les cavaliers de contact (17) montés côte à côte et rapprochés sur au moins un côté (10a) du montage hybride (10) sont pourvus de broches de connexion (21) qui sont recourbées alternativement dans la zone d'une branche (17a) et de l'autre branche (17b) de chaque cavalier de contact (17) dans la direction opposée à la branche (17a, b).

2. Montage hybride suivant la revendication 1, caractérisé en ce que les cavaliers de contact (17, 18) en forme de U sont montés sur deux faces opposées (10a, 10b) des deux substrats (11, 12) appliqués l'un sur l'autre.

3. Montage hybride selon la revendication 1, caractérisé en ce que dans la zone de la culasse (17c) des cavaliers de contact (17) en forme de U, une entretoise métallique est disposée, dont une des extrémités faisant saillie au-dessus de la zone de la culasse (17b) des cavaliers de contact (17) en forme de broche de connexion (21) est repliée à angle droit en direction opposée aux branches (17a, 17b).

FIG.2

FIG.1

FIG.3